(19)

**Europäisches Patentamt**
**European Patent Office**
**Office européen des brevets**

(11)  **EP 4 184 296 B1**

(12)  **EUROPEAN PATENT SPECIFICATION**

(45) Date of publication and mention
of the grant of the patent:
**31.12.2025  Bulletin 2026/01**

(51) International Patent Classification (IPC):
**G06F 3/044** (2006.01)     **G06F 3/041** (2006.01)
**H03K 17/96** (2006.01)     **G06F 3/0362** (2013.01)

(21) Application number: **22206327.3**

(22) Date of filing: **09.11.2022**

(52) Cooperative Patent Classification (CPC):
**G06F 3/0416; G06F 3/0362; G06F 3/0448;**
**H03K 17/962;** H03K 2017/9602; H03K 2217/96066

(54) **TOUCH SENSING ASSEMBLY AND ELECTRONIC DEVICE**

BERÜHRUNGSERFASSUNGSANORDNUNG UND ELEKTRONISCHE VORRICHTUNG

ENSEMBLE DE DÉTECTION TACTILE ET DISPOSITIF ÉLECTRONIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **17.11.2021  CN 202122812088 U**

(43) Date of publication of application:
**24.05.2023  Bulletin 2023/21**

(73) Proprietor: **Shenzhen Smoore Technology
Limited
Shenzhen, Guangdong 518102 (CN)**

(72) Inventors:
  • **TAN, Hua**
   **Guangdong (CN)**
  • **CHEN, Tao**
   **Guangdong (CN)**
  • **ZENG, Zhaohuan**
   **Guangdong (CN)**
  • **LI, Jun**
   **Guangdong (CN)**

(74) Representative: **Westphal, Mussgnug & Partner,
Patentanwälte mbB
Werinherstraße 79
81541 München (DE)**

(56) References cited:
**CN-A- 107 967 085     CN-A- 111 190 509
US-A1- 2012 239 327**

## Description

FIELD

The present disclosure relates to a touch sensing assembly and an electronic device.

BACKGROUND

Currently, a touch slider on an electronic cigarette generally adopts multiple sensing points to realize multi-point detection. The sensing points generally adopt a layout of equal size and equal length. When realizing a recognition of finger sliding with such a layout, pain points, such as a long finger sliding distance, and a long recognition time, always exist.

Publication CN 107 967 085 A pertains to a display device and is considered to be relevant to the present application. Publication CN 111 190 509 A pertains to a touch detection device and is also considered to be relevant to the present application.

SUMMARY

A technical problem to be solved by the present disclosure is, to provide a touch sensing assembly and an electronic device, for at least one foregoing defect in the prior art. This problem is solved by a touch sensing assembly having the features of claim 1.

A technical solution adopted by the present disclosure to solve the technical problem is to provide a touch sensing assembly, including a sliding gesture area, wherein the sliding gesture area includes at least one first sensing area located at each end of the sliding gesture area, and at least one second sensing area located in the middle of the sliding gesture area;

wherein the dimension of the first sensing area is larger than the dimension of the second sensing area.

In the touch sensing assembly of the present disclosure, the length of the first sensing area is larger than the length of the second sensing area in the length direction of the sliding gesture area.

Preferably, in the touch sensing assembly of the present disclosure, the lengths or the areas of the first sensing areas respectively at the two ends of the sliding gesture area are equal.

Preferably, in the touch sensing assembly of the present disclosure, the touch sensing assembly includes at least two second sensing areas that are sequentially arranged in the middle of the sliding gesture area.

Preferably, in the touch sensing assembly of the present disclosure, the lengths or the areas of the at least two second sensing areas in the middle of the sliding gesture area are equal.

Preferably, in the touch sensing assembly of the present disclosure, the intervals between the adjacent first sensing area and second sensing area and between the two adjacent second sensing areas are equal.

Preferably, in the touch sensing assembly of the present disclosure, at least one of the first sensing area and the second sensing area is long strip shaped.

In the touch sensing assembly of the present disclosure, the touch sensing assembly further includes a detection circuit corresponding to the first sensing areas and the second sensing area, configured to detect the capacitance values of the first sensing areas and the second sensing area.

Preferably, in the touch sensing assembly of the present disclosure, the first sensing areas and the second sensing area are flat structures.

Preferably, in the touch sensing assembly of the present disclosure, the detection circuit includes a pad and a processor; and

the pad corresponds to the first sensing area or the second sensing area, and is connected to the processor in a single wire connection.

The present disclosure further provides an electronic device, including the touch sensing assembly of any one of the above.

The implementation of the present disclosure provides the following beneficial effects:

the layout of unequal-sized sensing areas on the sliding gesture area is adopted in the present disclosure, that is, the area of the at least one first sensing area at each end of the two ends of the sliding gesture area is larger than the area of the at least one second sensing area in the middle of the sliding gesture area, so that the success rate of the wake-up of the processor after sleep can be ensured, and the effect of rapid recognition of the sliding action can be achieved.

BRIEF DESCRIPTION OF THE DRAWINGS

Subject matter of the present disclosure will be described in even greater detail below based on the exemplary figures. In the accompanying drawings:

FIG. 1 is a schematic diagram of a sliding gesture area of a touch sensing assembly of the present disclosure; and

FIG. 2 is a schematic diagram of a detection circuit of the present disclosure.

DETAILED DESCRIPTION

In order to have a clearer understanding of the technical features, the objectives, and the effects of the present disclosure, specific implementations of the present disclosure will be illustrated in detail with reference to the accompanying drawings.

In the following description, it should be understood that, the orientation or position relationship indicated in the specification is based on the orientation or position relationship shown in the accompanying drawings, or constructed and operated in a specific orientation, and is only for the convenience of describing the technical solutions of the present disclosure, rather than indicating that the device or element referred to must have a specific orientation, and therefore cannot be understood as a limitation of the disclosure.

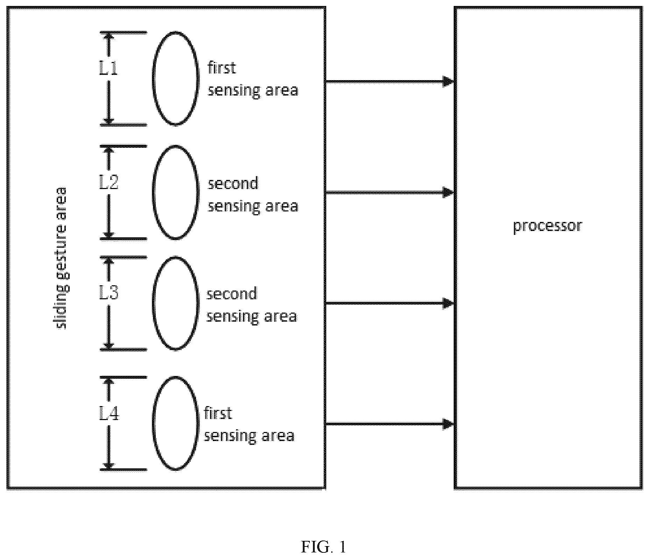

As shown in FIG. 1, the present disclosure discloses a touch sensing assembly, including a sliding gesture area. The sliding gesture area includes at least one first sensing area located at each end of the two ends of the sliding gesture area, and at least one second sensing area located in the middle of the sliding gesture area. The area of the first sensing area is larger than that of the second sensing area.

In some embodiments, the area of the first sensing area is larger than the area of the second sensing area, and the length of the first sensing area is larger than the length of the second sensing area in the length direction of the sliding gesture area, that is, the lengths of L1 and L4 are larger than the lengths of L2 and L3, so that the first sensing areas located at the two ends of the sliding gesture area can produce a larger capacitance change value. Meanwhile, the sliding distance of the user's finger from the first sensing area at one end of the sliding gesture area to the first sensing area at the other end of the sliding gesture area is less than the sliding distance of the equal-length sensing area. Since the sliding distance becomes shorter, the time of the finger sliding across the sensing area is shortened, thereby achieving the effect of rapid sliding recognition.

Wherein, in order to ensure that the sliding distance is as short as possible and the sliding action can be clearly detected, the lengths or areas of the first sensing areas respectively at the two ends of the sliding gesture area are equal, so that the capacitance change values at the two ends can be clearly distinguished from the capacitance change value in the middle when the capacitance change values at the two ends are equal. In other embodiments, the areas of the first sensing areas respectively at the two ends of the sliding gesture area are equal, and the lengths L1 and L4 of the first sensing areas at the two ends of the sliding gesture area are equal.

In some embodiments, in order to ensure the stability of sliding recognition, the touch sensing assembly includes at least two second sensing areas located in the middle of the sliding gesture area and arranged in sequence. In this way, if one of the second sensing areas is not touched, but another second sensing area is touched, the sliding action with large capacitance changes at the two ends and small capacitance change in the middle can also be recognized.

Further, in order to ensure that the sliding distance is as short as possible and the sliding action can be clearly detected, the at least two second sensing areas located in the middle of the sliding gesture area are equal in length or area, so that the capacitance change values in the middle can be clearly distinguished from the capacitance change values at the two ends when the capacitance change values in the middle are equal.

In other embodiments, the at least two second sensing areas located in the middle of the sliding gesture area and arranged in sequence have equal areas, and their lengths L2 and L3 are also equal. It should be noted that the touch sensing assembly is not limited to including two first sensing areas and two second sensing areas.

In some embodiments, in order to further achieve the effect of fast sliding recognition, the intervals between the adjacent first sensing area and second sensing area, and between the two adjacent second sensing areas are equal.

Further, the touch sensing assembly includes a detection circuit corresponding to the first sensing area and the second sensing area, which is configured to detect the capacitance values of the first sensing area and the second sensing area. In some embodiments, one or more detection circuits may be provided.

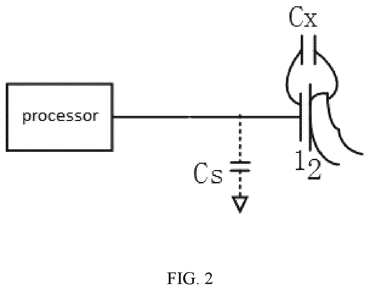

In some embodiments, as shown in FIG. 2, the detection circuit includes a pad 1 and a processor. The pad 1 corresponds to the first sensing area or the second sensing area. Specifically, the pad 1 is located below the first sensing area or the second sensing area, and the pad 1 is connected to the processor in a single wire connection. In some embodiments, the pad 1 may also be connected to the processor through a resistor. Wherein, the reference numeral 2 shown in FIG. 2 refers to the first sensing area or the second sensing area of a flat plate structure, and FIG. 2 also shows a case of a finger touching the sensing area. In some other embodiments, the processor is an MCU.

It should be noted that, a flat plate capacitor is composed of two parallel plates that are very close to each other. The capacitance between the two plates is proportional to the area S of the plate and inversely proportional to the distance d between the plates. The finger and the pad 1 may be regarded as two parallel plates. Therefore, preferably, the first sensing area and the second sensing area are flat plate structures, that is, the position for the user to touch is flat plate. The contact area of the flat plate structure is large, thereby the sliding action is easy to identify.

The detection principle of the touch button is realized through the change of the RC charging time, mainly the change of the capacitance value. With the surrounding environment unchanged, the capacitance of the PCB board of the pad 1 and the detection circuit is a very small fixed value $Cs$. When the finger is close to sensing area 2, the whole capacitance will change, that is, $Cs + Cx$, thereby the RC charging time is changed to achieve the touch detection. The capacitance between the flat plate capacitors is proportional to the contact area and inversely proportional to the contact distance.

The calculation formula of the capacitance between the flat plate capacitors is as follows:

$$C = K \times \frac{S}{d}$$

Wherein, K is the dielectric constant, S is the contact area, d is the distance between the two plates, and C is the capacitance value.

When the relative distance between the finger and the sensing area is a fixed value, the capacitance change value that the processor can detect is only related to the relative area. Since the sensing areas at the two ends are larger, when a touch signal is generated, the processor can read a larger capacitance change value. The sensing areas in the middle are smaller, thus the capacitance change value is smaller. In this way, the position of the sensing area pressed by the finger can be identified. By reading the capacitance change values of the sensing areas in sequence, the action of the finger on the sensing areas can also be identified. When the capacitance values are detected to have a change of "large-small-small-large" within a certain period of time, a sliding action is recorded.

When the processor sleeps, a timing wake-up scanning method is used to detect whether there is a signal output in the sensing area in the prior art. In order to save power, the scanning interval during the sleep is relatively long. However, when used in the sliding gesture recognition, due to the sliding speed of the finger is high, the sensing areas at the two ends cannot be too small, and need to be as large as possible and as long as possible to increase the touching time with the finger, so that there is enough time to wake up the processor, thereby improving the success rate of waking up the processor. However, in the traditional layout, a plurality of sensing areas with the same length and the same size are adopted, so that pain points such as a long finger sliding distance, and a long recognition time, always exist. For this purpose, a new application is specially proposed, wherein the layout of the sensing areas with unequal size is adopted on the sliding feature area, and the areas of the first sensing areas at the two ends are larger than the areas of the second sensing areas in the middle. Further, the lengths of the first sensing areas at the two ends are longer, and the lengths of the second sensing areas in the middle are shorter, so that the first sensing areas at the two ends can produce larger capacitance changes. Meanwhile, the distance from the first sensing area (the first pad) to the fourth sensing area (the fourth pad) is L1+ L2+ L3+ L4, which is less than the distance 4*L1 of a equal-length sensing area, so that the time of the finger passing through the sensing area is shortened due to the distance is shortened, thereby achieving the effect of fast sliding recognition. Besides, since the first sensing areas at the two ends are large enough and long enough, the wake-up of the processor will not be affected due to the sensing area is too small or too short. After the wake-up, the scanning time interval is greatly shortened, and the second sensing areas in the middle can recognize the signal. This design can not only ensure the success rate of the wake-up of the processor after sleep, but also realize rapid recognition of the sliding action.

In some embodiments, at least one of the first sensing areas or the second sensing areas is in a long strip shape, in order to further avoid that the sensing area is too short to affect the wake-up of the processor.

In some embodiments, the first sensing area and the second sensing area may be disposed according to the shape of the sliding gesture area. For the diversity of the sliding gestures, the sliding gesture area may be in an arc shape or a long strip shape. The long strip shape may be, for example, an elliptical shape or a rectangular shape. The arc shape may be, for example, a crescent shape or a semicircle shape. In other embodiments, the sliding gesture area may not be limited to an arc shape or a long strip shape.

The present disclosure further discloses an electronic device, including the touch sensing assembly described in any of the above, which will not be repeated herein.

The implementation of the present disclosure provides the following beneficial effects:

The present disclosure adopts the layout of unequalsized sensing areas on the sliding gesture area, that is, the area of the at least one first sensing areas at each end of the sliding gesture area is larger than the area of the at least one second sensing area in the middle of the sliding gesture area, so that the success rate of the wake-up of the processor after sleep can be ensured, and the effect of rapid recognition of the sliding action can be achieved.

While the disclosure has been illustrated and described in detail in the drawings and foregoing description, such illustration and description are to be considered illustrative or exemplary and not restrictive. It will be understood that changes and modifications may be made by those of ordinary skill within the scope of the following claims. In particular, the present disclosure covers further embodiments with any combination of features from different embodiments described above and below. Additionally, statements made herein characterizing the disclosure refer to an embodiment of the disclosure and not necessarily all embodiments.

**Claims**

1. A touch sensing assembly, comprising:

   a sliding gesture area;
   wherein the sliding gesture area comprises first sensing areas located at each of two ends of the sliding gesture area and at least one second sensing area located in a middle of the sliding gesture area;
   wherein a dimension of the first sensing areas is larger than a dimension of the at least one second sensing area,

wherein a length of the first sensing areas is larger than a length of the at least one second sensing area in a length direction of the sliding gesture area,

wherein the touch sensing assembly further comprises a detection circuit corresponding to the first sensing areas and the at least one second sensing area, configured to detect the capacitance values of the first sensing areas and the at least one second sensing area, wherein the detection circuit is configured to detect a finger sliding across the sliding gesture area,

wherein the first sensing areas and the at least one second sensing area are flat structures, wherein the detection circuit comprises a plurality of pads (1) and a processor,

wherein each pad (1) corresponds to a respective one of the first sensing areas and the at least one second sensing area, and is connected to the processor in a single wire connection, and wherein when the processor sleeps, it is configured to wake up when a sliding gesture is carried out over the sliding gesture area.

2. The touch sensing assembly of claim 1, wherein the lengths or the areas of the first sensing areas respectively at the two ends of the sliding gesture area are equal.

3. The touch sensing assembly of claim 1, wherein the at least one second sensing area comprises at least two second sensing areas that are sequentially arranged in the middle of the sliding gesture area.

4. The touch sensing assembly of claim 3, wherein the lengths or the areas of the at least two second sensing areas in the middle of the sliding gesture area are equal.

5. The touch sensing assembly of claim 3, wherein the intervals between the adjacent first sensing area and second sensing area and between the two adjacent second sensing areas are equal.

6. The touch sensing assembly of claim 1, wherein at least one of the first sensing areas and the at least one second sensing area is long strip shaped.

7. An electronic device, comprising:
the touch sensing assembly of any one of claims 1 to 6.

**Patentansprüche**

1. Berührungserfassungsanordnung, umfassend:

einen Gleitgestenbereich;

wobei der Gleitgestenbereich erste Erfassungsbereiche, die sich an jedem von zwei Enden des Gleitgestenbereichs befinden, und mindestens einen zweiten Erfassungsbereich, der sich in einer Mitte des Gleitgestenbereichs befindet, umfasst;

wobei eine Abmessung der ersten Erfassungsbereiche größer ist als eine Abmessung des mindestens einen zweiten Erfassungsbereichs, wobei eine Länge der ersten Erfassungsbereiche größer ist als eine Länge des mindestens einen zweiten Erfassungsbereichs in einer Längenrichtung des Gleitgestenbereichs,

wobei die Berührungserfassungsanordnung ferner eine Detektionsschaltung umfasst, die den ersten Erfassungsbereichen und dem mindestens einen zweiten Erfassungsbereich entspricht, die dazu konfiguriert ist, die Kapazitätswerte der ersten Erfassungsbereiche und des mindestens einen zweiten Erfassungsbereichs zu detektieren, wobei die Detektionsschaltung dazu konfiguriert ist, einen über den Gleitgestenbereich gleitenden Finger zu detektieren, wobei die ersten Erfassungsbereiche und der mindestens eine zweite Erfassungsbereich flache Konstruktionen sind,

wobei die Detektionsschaltung eine Vielzahl von Pads (1) und einen Prozessor umfasst, wobei jedes Pad (1) einem jeweiligen der ersten Erfassungsbereiche und des mindestens einen zweiten Erfassungsbereichs entspricht und mit dem Prozessor über eine Einzeldrahtverbindung verbunden ist, und

wobei der Prozessor, wenn er inaktiv ist, dazu konfiguriert ist, aktiviert zu werden, wenn eine Gleitgeste über den Gleitgestenbereich durchgeführt wird.

2. Berührungserfassungsanordnung nach Anspruch 1, wobei die Längen oder die Bereiche der ersten Erfassungsbereiche jeweils an den zwei Enden des Gleitgestenbereichs gleich sind.

3. Berührungserfassungsanordnung nach Anspruch 1, wobei der mindestens eine zweite Erfassungsbereich mindestens zwei zweite Erfassungsbereiche umfasst, die nacheinander in der Mitte des Gleitgestenbereichs angeordnet sind.

4. Berührungserfassungsanordnung nach Anspruch 3, wobei die Längen oder die Bereiche der mindestens zwei zweiten Erfassungsbereiche in der Mitte des Gleitgestenbereichs gleich sind.

5. Berührungserfassungsanordnung nach Anspruch 3, wobei die Abstände zwischen dem ersten Erfassungsbereich und dem benachbarten zweiten Erfassungsbereich und zwischen den zwei benachbarten zweiten Erfassungsbereichen gleich sind.

6. Berührungserfassungsanordnung nach Anspruch 1, wobei mindestens einer der ersten Erfassungsbereiche und des mindestens einen zweiten Erfassungsbereichs als langer Streifen geformt ist.

7. Elektronische Vorrichtung, umfassend: die Berührungserfassungsvorrichtung nach einem der Ansprüche 1 bis 6.

**Revendications**

1. Ensemble de détection tactile, comprenant :

une zone de geste de glissement ;
dans lequel la zone de geste de glissement comprend des premières zones de détection situées au niveau de chacune des deux extrémités de la zone de geste de glissement et au moins une seconde zone de détection située au milieu de la zone de geste de glissement ;
dans lequel une dimension des premières zones de détection est plus grande qu'une dimension de l'au moins une seconde zone de détection,
dans lequel une longueur des premières zones de détection est plus grande qu'une longueur de l'au moins une seconde zone de détection, dans une direction longitudinale de la zone de geste de glissement,
dans lequel l'ensemble de détection tactile comprend également un circuit de détection correspondant aux premières zones de détection et à l'au moins une seconde zone de détection, configuré pour détecter les valeurs de capacité des premières zones de détection et de l'au moins une seconde zone de détection, dans lequel le circuit de détection est configuré pour détecter un doigt glissant sur la zone de geste de glissement,
dans lequel les premières zones de détection et l'au moins une seconde zone de détection sont des structures plates,
dans lequel le circuit de détection comprend une pluralité d'électrodes (1) et un processeur,
dans lequel chaque électrode (1) correspond à une zone de détection respective des premières zones de détection et à l'au moins une seconde zone de détection, et est connecté au processeur par une connexion à fil unique, et
dans lequel, lorsque le processeur est en veille, il est configuré pour se réveiller lorsqu'un geste de glissement est effectué sur la zone de geste de glissement.

2. Ensemble de détection tactile selon la revendication 1, dans lequel les longueurs ou les surfaces des premières zones de détection respectivement au niveau des deux extrémités de la zone de geste de glissement sont égales.

3. Ensemble de détection tactile selon la revendication 1, dans lequel l'au moins une seconde zone de détection comprend au moins deux secondes zones de détection qui sont disposées séquentiellement au milieu de la zone de geste de glissement.

4. Ensemble de détection tactile selon la revendication 3, dans lequel les longueurs ou les surfaces des au moins deux zones de détection au milieu de la zone de geste de glissement sont égales.

5. Ensemble de détection tactile selon la revendication 3, dans lequel les intervalles entre la première zone de détection adjacente et la seconde zone de détection et entre les deux secondes zones de détection adjacentes sont égaux.

6. Ensemble de détection tactile selon la revendication 1, dans lequel au moins l'une des premières zones de détection et de l'au moins une seconde zone de détection est en forme de longue bande.

7. Dispositif électronique, comprenant : l'ensemble de détection tactile selon l'une quelconque des revendications 1 à 6.

FIG. 1

FIG. 2

**EP 4 184 296 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 107967085 A

- CN 111190509 A